# EUROPEAN PATENT APPLICATION

(11) **EP 4 546 412 A1**
(43) Date of publication of application: **30.04.2025**
(21) Application number: 23826946.8
(22) Date of filing: 01.06.2023
(51) Int. Cl.: H01L 23/473

(54) **COOLING STRUCTURE, AND STRUCTURE**

(30) Priority: 21.06.2022 JP 2022099723
(71) Applicant: Resonac Corporation, Tokyo 105-7325 (JP)
(72) Inventor: FUKUKAWA, Yuji, Tokyo 105-8518 (JP); YAMASHITA, Takahiro, Tokyo 105-8518 (JP); ITO, Seiichi, Tokyo 105-8518 (JP); SHODA, Hiroaki, Tokyo 105-8518 (JP)
(74) Representative: Berggren Oy
(86) International application number: PCT/JP2023/020553
(87) International publication number: WO 2023/248759

(57) **Abstract**

A cooling structure includes an outer packaging material having an inlet and an outlet for a refrigerant, and an inner core material disposed inside the outer packaging material. The inner core material includes a resin, and the cooling structure further includes a reinforcing member disposed inside the outer packaging material for reinforcing the inner core material.

## Description

### Technical field

The present disclosure relates to a cooling structure, and a structure.

### Background Art

In the field of electronic devices such as smartphones and personal computers, and battery modules mounted on electric vehicles, hybrid vehicles and the like, techniques for incorporating water-cooling devices, heat pipes and the like as heat generation countermeasures are known. Also, in power semiconductor modules made of silicon carbide or the like, measures using cooling plates, heat sinks or the like as heat generation countermeasures have been proposed.

For example, vehicles equipped with motors such as hybrid cars and electric cars, are equipped with a driving means for driving the motor. The driving means is composed of a power module having a plural power semiconductor such as an IGBT (Insulated Gate Bipolar Transistor), an electronic component such as a capacitor, and a bus bar that electrically connect these electronic components. When driving a motor, a large current may flow through the bus bar that connects the power semiconductors, capacitors and the like. In this case, the driving means generates heat due to switching loss, resistance loss and the like, and therefore it is desirable to efficiently cool the driving means. It is also desirable to efficiently cool the heat generated by the battery module installed in the vehicle.

A cooling structure may be a structure made of a metal with high thermal conductivity, such as an aluminum cooling fin core structure. However, since it is made of metal, it is heavy, and since it needs to be attached to an object to be cooled by welding or the like, it needs to be a certain thickness, which makes it difficult to make it thin.

Therefore, from the viewpoint of reducing weight, and the like, a cooling structure has been proposed in which an outer packaging material and an inner core material are made of a laminate material in which a metal heat transfer layer is laminated with resin layer, and a refrigerant is circulated through a flow path separated by the inner core material (see, for example, Patent Document 1). It is described that a heat exchanger of Patent Document 1 can be sufficiently thinned because it is produced by heat fusing laminate materials having a heat fusion layer. Furthermore, in the heat exchanger described in Patent Document 1, the shape and size of the laminated materials that serve as the exterior material and the inner core material can be easily changed, which is said to increase design freedom and improve versatility.

### Related Art Documents

### Patent Documents

Patent Document 1: Japanese Patent Application Laid-Open (JP-A) No. 2020-3132

### SUMMARY OF INVENTION

The cooling structure described in Patent Document 1 is lightweight and easy to handle, but since the water channels are made of laminate material, external forces such as a weight of the object to be cooled placed on the cooling structure may deform the laminate material and crush the water channels, resulting in a decrease in cooling performance. In view of such circumstances, the present disclosure relates to providing a cooling structure and a structure that are lightweight and can suppress a significant decrease in cooling performance due to pressure from the object to be cooled or the like.

### Solution to Problem

Means for solving the above problems include the following embodiments.
<1> A cooling structure comprising an outer packaging material having an inlet and an outlet for a refrigerant, and an inner core material disposed inside the outer packaging material, in which:
   the inner core material includes a resin, and
   the cooling structure is provided with a reinforcing member that reinforces the inner core material and that is disposed inside the outer packaging material
<2> The cooling structure according to claim 1, in which the reinforcing members are disposed symmetrically in a width direction of the cooling structure.
<3> The cooling structure according to claim 1, in which a height of the reinforcing member is 70% or more of a distance in the thickness direction of the cooling structure inside the outer packaging material.
<4> The cooling structure according to claim 1, in which the outer packaging material includes a metal layer and a resin layer disposed on at least one side of the metal layer.
<5> The cooling structure according to claim 1, in which the inner core material includes a metal layer and a resin layer disposed on both sides of the metal layer.
<6> A structure including the cooling structure according to any one of <1> to <5> and an object to be cooled provided on the cooling structure.

### Advantageous Effects of Invention

According to the present disclosure, it is possible to provide a cooling structure and a structure that are lightweight and can suppress a significant decrease in cooling performance due to pressure from the object to be cooled or the like.

### BRIEF DESCRIPTION OF DRAWINGS

FIG. 1 is a schematic perspective view showing an appearance of a cooling structure 100 of one embodiment in the present disclosure.
FIG. 2 is an exploded view of the cooling structure 100 of FIG. 1, separated into its individual components.
FIG. 3 is a schematic perspective view of a portion of an inner core material 40 of one embodiment in the present disclosure.
FIG. 4 is a schematic cross-sectional view of a portion in a width direction of a cooling structure of an embodiment in the present disclosure.
FIG. 5 is a schematic cross-sectional view of a portion in a width direction of a cooling structure of another embodiment in the present disclosure.
FIG. 6 is a schematic cross-sectional view of a portion in a width direction of a cooling structure of another embodiment in the present disclosure.
FIG. 7 is a schematic perspective view of an inner core material 40 in another embodiment in the present disclosure.
FIG. 8 is a schematic perspective view illustrating a modified example of the cooling structure, showing an interior in a case in which an upper outer packaging material 30B is removed.

### DESCRIPTION OF EMBODIMENTS

Hereinafter, embodiments in the present disclosure will be described in detail. It is to be noted, however, that the present disclosure is not limited to the following embodiments. In the embodiments described below, components thereof (including element steps and the like) are not essential, unless otherwise specified. The same applies to numerical values and ranges thereof, and the present disclosure is not limited thereto.

In a case in which the embodiments in the present disclosure are described with reference to the drawings, a configuration of embodiments is not limited to the configuration shown in the drawings. Furthermore, the sizes of the members in each figure are conceptual, and the relative size relationships between the members are not limited thereto. Further, in each drawing, members having substantially the same function are given the same reference numerals in all drawings, and duplicated explanations will be omitted.

In the present disclosure, the term "layer" comprehends herein not only a case in which the layer is formed over the whole observed region where the layer is present, but also a case in which the layer is formed only on part of the region.

In the present disclosure, the term "laminate" refers to stacking layers, and two or more layers may be joined, or two or more layers may be detachable.

### <Cooling structure>

A cooling structure in the present disclosure includes an outer packaging material having an inlet and an outlet for a refrigerant, and an inner core material disposed inside the outer packaging material, in which the inner core material includes a resin, and the cooling structure is provided with a reinforcing member that reinforces the inner core material and that is disposed inside the outer packaging material.

The heat exchanger described in Patent Document 1 is constituted by an inner core material that is formed by pleating a laminate material to form a plurality of convex and concave shapes that is arranged in the thickness direction of the cooling structure, and therefore has a certain degree of strength against loads from the thickness direction of the cooling structure.

However, depending on a weight of the object to be cooled, the outer packaging material and inner core material constituted, which are made of the laminate materials, may deform, causing the water channels to collapse and reducing a flow rate of the refrigerant, which may result in a decrease in cooling capacity.

As a remedy for such a defect, it is possible to consider strengthening the outer packaging material or the like. However, this measure prevents the cooling structure from being lightweight and increases the overall size of the cooling structure, thereby negating the benefits of using a laminate material.

In contrast, the cooling structure in the present disclosure includes an inner core material containing resin to reduce weight, while a reinforcing member is provided inside the outer packaging material, whereby there may be no need to increase the overall size of the cooling structure. Therefore, according to the cooling structure in the present disclosure, there may be no increase in the mounting space required for an automobile or the like.

A position of the reinforcing member in the cooling structure is not particularly limited as long as it is inside the outer packaging material. Since the object to be cooled is mounted in layers in the thickness direction of the cooling structure, the reinforcing member has a function of reinforcing the inner core material against external forces from the thickness direction of the cooling structure. It is preferable that the reinforcing member is provided inside the outer packaging material and extends in the thickness direction of the cooling structure.

A number of reinforcing members in the cooling structure is not particularly limited. For example, the reinforcing member may be designed to be positioned according to a mounting position of the object to be cooled, or the reinforcing member may be provided in the cooling structure in advance, and the object to be cooled may be placed at the position of the reinforcing member. In the latter case, in a case in which multiple reinforcing members are provided in the cooling structure, the cooling structure will have a higher degree of freedom in the mounting position of the object to be cooled.

The reinforcing members are preferably disposed symmetrically in a width direction of the cooling structure. In a case in which the reinforcing members are disposed symmetrically in the width direction, a strength in the width direction is equalized against the load applied in the thickness direction of the cooling structure.

Hereinafter, the cooling structure in the present disclosure will be described with reference to the drawings. Note that the embodiments in the present disclosure are not limited to the aspects shown in the drawings.

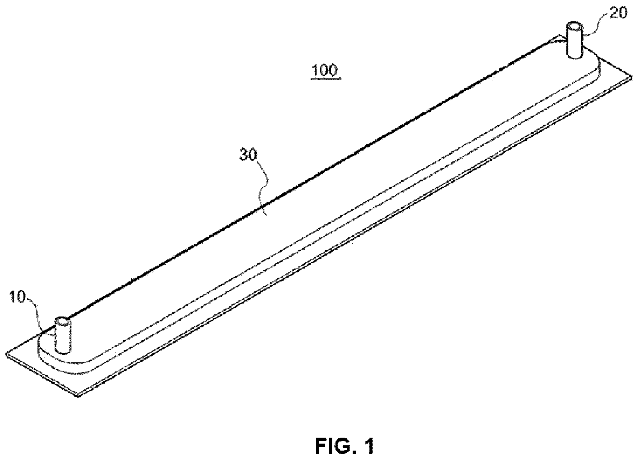

FIG. 1 is a schematic perspective view showing an appearance of a cooling structure 100 of one embodiment in the present disclosure. The cooling structure 100 shown in FIG. 1 has an inlet 10 and an outlet 20 for a refrigerant, and is entirely covered with an outer packaging material 30.

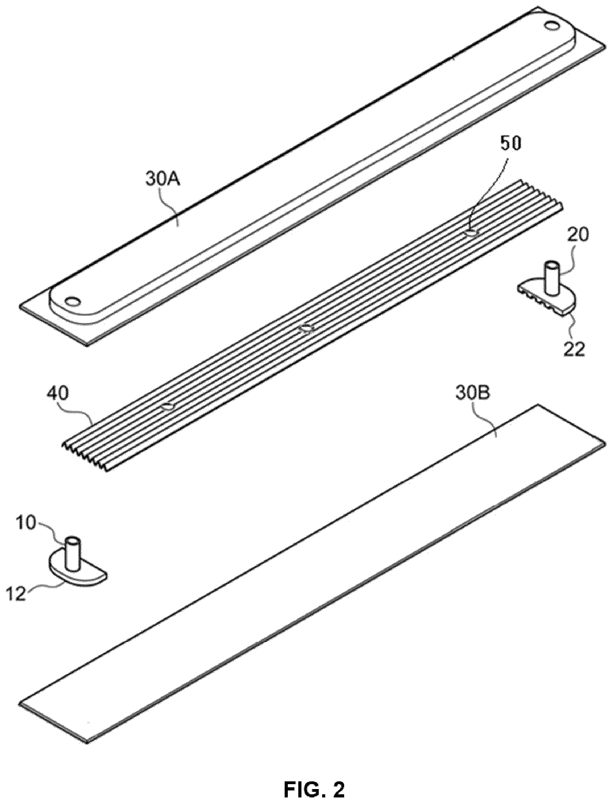

FIG. 2 is an exploded view of the cooling structure 100 of FIG. 1, separated into its individual components.

The outer packaging material 30 is composed of an upper outer packaging material 30A and a lower outer packaging material 30B. In the present disclosure, the upper and lower are written according to a top and bottom in the drawings, but the top and bottom may be reversed.

The upper outer packaging material 30A is provided with holes for passing through a joint pipe as the inlet 10 and a joint pipe as the outlet 20. From the viewpoint of fixing the joint pipes and assembling, it is preferable that the joint pipe of the inlet 10 is provided as a part of a header part 12, and the joint pipe of the outlet 20 is provided as a part of a footer part 22. The joint pipe of the inlet 10 may be molded integrally with the header part 12, and the joint pipe of the outlet 20 may be molded integrally with the footer part 22.

In the cooling structure 100 of FIGs 1 and 2, the joint pipes extends outward in a thickness direction of the cooling structure 100, but the orientation of the joint pipes are not limited to this. For example, the joint pipes may extend outward in a surface direction of the cooling structure 100. Alternatively, the joint pipe of the inlet 10 and the joint pipe of the outlet 20 may be oriented in different directions.

An inner core material 40 is disposed inside the outer packaging material 30. The inner core material 40 divides the flow path of the refrigerant flowing from the header part 12 to the footer part 22 into multiple parts. A periphery of the upper outer packaging material 30A and the lower outer packaging material 30B are closed to seal. In a case in which the upper outer packaging material 30A and the outer packaging material 30B have a resin layer, the periphery of the upper lower outer packaging material 30A and the lower outer packaging material 30B may be closed and sealed by fusing the resin layer.

A reinforcing member 50 for reinforcing the inner core material 40 is provided inside the outer packaging material 30. A shape of the reinforcing member 50 is not limited, and may be a cylinder, a prism, a cone, a pyramid, or the like.

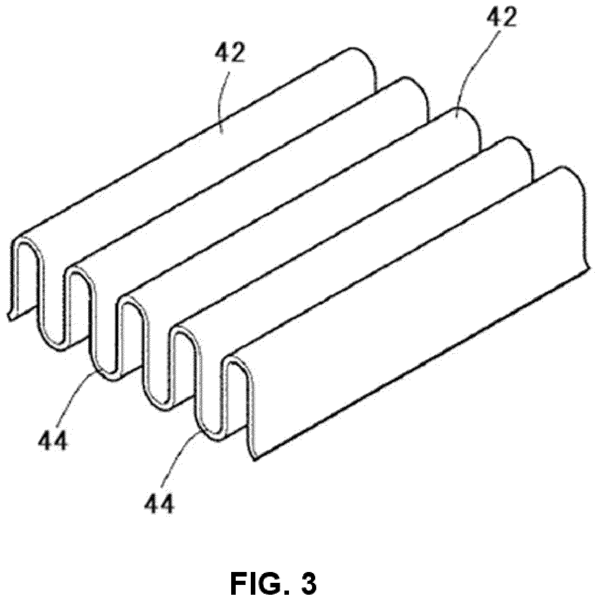

FIG. 3 is a schematic perspective view of a portion of an inner core material 40 of one embodiment in the present disclosure. The inner core material 40 has a concave and convex shape that divide a flow path of a refrigerant into multiple parts, and has multiple convex portions 42 and multiple concave portions 44.

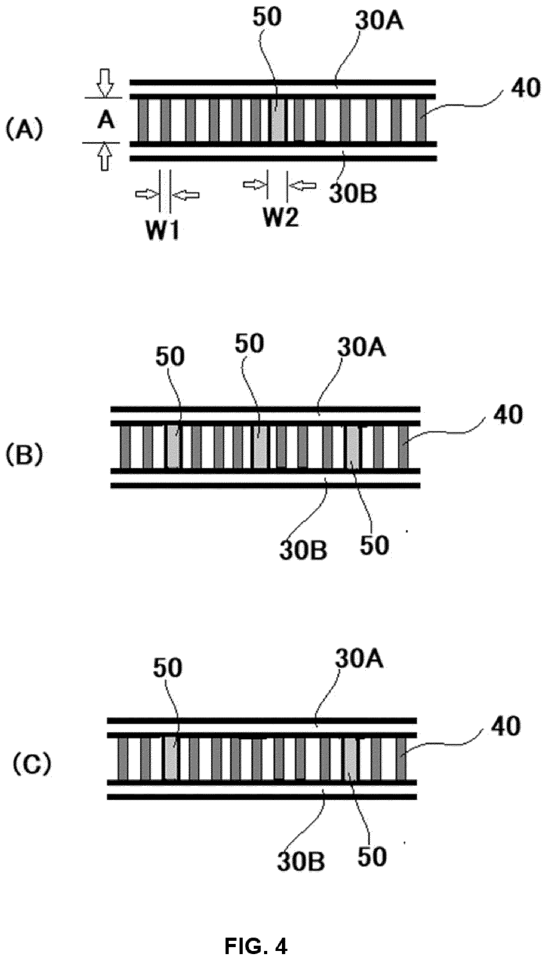

FIG. 4 is a schematic cross-sectional view of a portion in a width direction of a cooling structure of an embodiment in the present disclosure. The reinforcing member 50 is provided extending in the thickness direction of the cooling structure 100 from the outer packaging material 30B to the outer packaging material 30A. In the cooling structure of Fig. 4(A), one reinforcing member 50 is disposed at the center of the cooling structure in the width direction. In the cooling structure of Fig. 4(B), one reinforcing member 50 is disposed at the center of the cooling structure in the width direction, and one reinforcing member 50 is disposed on each side in the width direction, for a total of three reinforcing members. In the cooling structure of Fig. 4(C), one reinforcing member 50 is disposed on each side in the width direction of the cooling structure, for a total of two reinforcing members.

A material of the reinforcing member 50 is not particularly limited, and examples thereof include at least one selected from the group consisting of organic substances such as resins, inorganic substances, and metals, and specifically include aluminum. It is preferable that the reinforcing member 50 is constructed using a material having a higher strength than the resin used for the inner core material 40. In a case in which the reinforcing member 50 is made of a material stronger than the resin of the inner core material 40, its strength may be maintained even if the width of the reinforcing member is narrower than that of the inner core material, and an by providing the reinforcing member, an area in which the flow path is crushed may be made small.

A width W2 of the reinforcing member 50 relative to a width W1 of the inner core material 40 (in a case in which the inner core material is a laminate material, the width W1 corresponds to a thickness of the laminate material) can be adjusted appropriately depending on the material.

Here, the width W1 of the inner core material 40 means a size of the inner core material 40 in the width direction of the cooling structure, and the width of the reinforcing member 50 means a size of the reinforcing member 50 in the width direction of the cooling structure.

In a case in which the flow path is divided into multiple sections by the inner core material 40 in the width direction of the cooling structure, the width W1 of the inner core material 40 means a thickness of each wall that separates the flow path (a size of the wall in the width direction of the cooling structure).

In a case in which multiple reinforcing members 50 are present in the width direction of the cooling structure, the width W2 of the reinforcing members 50 refers to a size of each reinforcing member 50 in the width direction of the cooling structure.

In a case in which the reinforcing member 50 is made of a resin with a strength similar to that of the resin used in the inner core material 40, the width W2 of the reinforcing member 50 may be made wider than the width W1 of the inner core material 40 to reinforce the inner core material 40. However, even when the reinforcing member 50 is made of a material with a strength higher than that of the resin used in the inner core material 40, the width W2 of the reinforcing member may be made wider than the width W1 of the inner core material 40.

As an example, the width W2 of the reinforcing member 50 relative to the width W1 of the inner core material 40 may be 70% or less, 60% or less, or 50% or less.

A length of the reinforcing member 50 in the longitudinal direction of the cooling structure is not particularly limited.

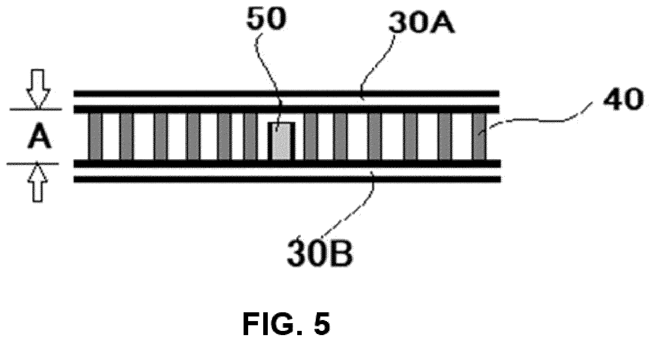

As shown in FIG. 4, in a case in which the distance A from the outer packaging material 30B to the outer packaging material 30A in the thickness direction of the cooling structure is taken as 100%, the height B of the reinforcing member 50 may be 100%, but as shown in FIG. 5, it may be less than 100%, or may be 95% or less. The reference "distance A" is measured in a state where no external force is applied.

FIG. 5 is a schematic cross-sectional view of a portion in a width direction of a cooling structure of another embodiment in the present disclosure, and is an example in which the height B of the reinforcing member 50 is less than 100% of the distance A. In a case in which the height B of the reinforcing member 50 is taken as less than 100%, there is a margin in the difference between the distance A and the height B. Therefore, in such a cooling structure, even if at least one of the cooling structure or the object to be cooled expands and contracts due to heating or cooling, it is possible to respond to a deformation of the expansion or contraction. Furthermore, even if there is deformation other than expansion or contraction, for example, deformation of the cooling structure due to an external force, the reinforcing function in the thickness direction of the cooling structure may be maintained.

The height B of the reinforcing member 50 is preferably 70% or more, and may be 80% or more, or may be 90% or more, with respect to of a distance inside the outer packaging material in the thickness direction of the cooling structure (i.e., the distance A from the outer packaging material 30B to the outer packaging material 30A). In a case in which the height B of the reinforcing material 50 is 70% or more, even if the water channel is crushed by pressure from the thickness direction of the cooling structure, a certain amount of refrigerant may be ensured to flow.

The height B of the reinforcing member 50 may be 100% of the distance A, or it may be less than 100%, or it may be 95% or less.

In FIG. 5, one reinforcing member 50 having a height B less than 100% of the distance A is provided in the center part in the width direction of the cooling structure 100, but two or more may be provided. In this case, the height B of each reinforcing member 50 may be the same, or the height B of the reinforcing member 50 may be changed depending on a surface shape of the object to be cooled.

In addition, although the reinforcing member 50 is attached to the outer packaging material 30B side in Figure 5, it may be attached to the outer packaging material 30A side.

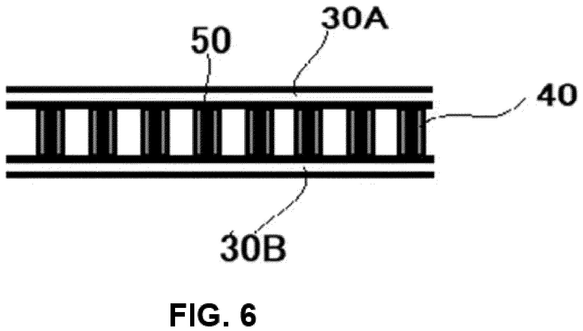

FIG. 6 is a schematic cross-sectional view of a portion in a width direction of a cooling structure of another embodiment in the present disclosure, showing a modified example of the reinforcing member 50.

In FIG. 6, the reinforcing member 50 is integrated with the inner core material 40. In FIG. 6, the reinforcing member 50 is provided inside the inner core material 40, but the reinforcing member 50 may be provided on the surface of the inner core material 40. In a case in which the reinforcing member 50 is made of metal or the like, it is preferable to provide the reinforcing member 50 inside the inner core material 40 from the viewpoint of preventing corrosion.

In a case in which the reinforcing member 50 is provided as a part of the inner core 40, the height of the inner core 40 and the height of the reinforcing member 50 may be the same or different. For example, in the embodiment of FIG. 6, a height of the reinforcing member 50 may be 100% with respect to a height of the inner core 40, may be less than 100%, or may be 95% or less. Furthermore, the height of the reinforcing member 50 is preferably 70% or more with respect to the height of the inner core 40, may be 80% or more, or may be 90% or more.

In a case in which the height of the reinforcing member 50 is lower than the height of the inner core 40 and an external force is applied from the thickness direction of the cooling structure, since the inner core 40 is made of resin, an elasticity of the resin of the inner core 40 may allow deformation at least up to the height of the reinforcing member 50.

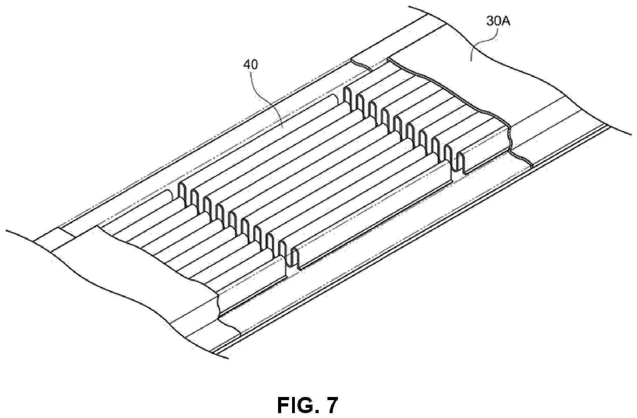

FIG. 7 is a schematic perspective view of an inner core material 40 in another embodiment in the present disclosure. As shown in FIG. 7, the inner core 40 may be separated into two or more parts in the length direction. In this case, the reinforcing member 50 may be provided at the separation position of the inner core material 40. Also, the reinforcing member 50 may be provided at a position other than the separation position of the inner core material 40.

Hereinafter, the outer packaging material 30, the inner core material 40 and the like will be described in detail.

From the viewpoint of closing the periphery of the outer packaging material 30A and the outer packaging material 30B by fusion, it is preferable that the outer packaging material 30 has a metal layer and a resin layer provided on at least one side of the metal layer. By providing a resin layer on an inside surface of the outer packaging material 30, an occurrence of corrosion due to the refrigerant is easily suppressed. Whereas, by providing a resin layer on an outside surface of the outer packaging material 30, insulation may be achieved. It is preferable that the outer packaging material 30 has resin layers provided on both sides of the metal layer. The lower outer packaging material 30A and the upper outer packaging material 30B may be made of the same material or different materials.

Examples of the metal layer include aluminum foil, stainless steel foil, nickel foil, plated copper foil, and clad metal of nickel foil and copper foil. From the viewpoint of thermal conductivity, cost or the like, aluminum foil is preferable.

A thickness of the metal layer is preferably 4 µm or more, and more preferably 8 µm or more. The thickness of the metal layer is preferably 300 µm or less, and more preferably 150 µm or less.

The resin layer is preferably composed of a resin having thermal fusion property, and examples of the resin include a polyolefin resin such as polyethylene, polypropylene or modified resins thereof, a fluorine-based resin, a polyester resin such as PET resin, and vinyl chloride resin.

A thickness of the resin layer is preferably 4 µm or more, and more preferably 8 µm or more. The thickness of the resin layer is preferably 300 µm or less, and more preferably 150 µm or less.

The metal layer and the resin layer may be laminated to form a laminate material. Another layer may or may not be provided between the metal layer and the inner resin layer.

A coating layer may be provided on the outermost layer of the laminate material. By providing the coating layer on the outer packaging material 30, a corrosion of the metal layer is prevented, and damage due to external and internal pressure tends to be prevented. In addition, in a case in which an insulating resin is used for the coating layer, it tends to be possible to impart effects such as preventing short circuits and electric leakage to the object to be cooled. Whereas, in a case in which a conductive resin is used for the coating layer, it tends to be possible to impart an antistatic effect to the object to be cooled.

As the resin for the coating layer, the same resin as that for the resin layer described above may be used. The coating layer may be made of the same material as the resin layer, or a different material. From the viewpoint of heat-sealing the resin layer of the outer packaging material 30 and the inner core material 40 while not requiring the coating layer to be heat-sealed, it is preferable to use a coating layer having a higher melting point than the resin layer, and it is particularly preferable to use a resin having a melting point 10°C or more higher.

A thickness of the coating layer is not particularly limited, and it is preferable to set it to the same thickness as the resin layer or thinner than the resin layer.

A thickness of the outer packaging material 30 is not particularly limited. From the viewpoint of strength and thermal conductivity, it is preferable that the thickness of the outer packaging material 30 is 8 µm or more, more preferably 10 µm or more, and even more preferably 12 µm or more. From the viewpoint of thinning and deformability, it is preferable that the thickness of the outer packaging material 30 is 300 µm or less, more preferably 250 µm or less, and even more preferably 200 µm or less. From these viewpoints, the thickness of the outer packaging material 30 is preferably from 8 µm to 300 µm, more preferably from 10 µm to 250 µm, and even more preferably from 12 µm to 200 µm.

The laminate material may be produced by attaching a resin film to a metal foil or metal plate. The resin film may be a stretched film or a non-stretched film. An adhesive may be used for attachment.

The inner core material 40 includes a resin and may be a laminate material in which a metal layer and a resin layer are laminated. The inner core material 40 may have a metal layer and resin layers provided on both sides of the metal layer. In a case in which the surface of the inner core material 40 is made of resin, it may be fused to the outer packaging material 30. Furthermore, in a case in which the surface of the inner core material 40 is made of resin, an occurrence of corrosion due to the refrigerant is more easily suppressed.

The metal layer of the inner core material 40 may suitably be the same as the metal layer of the outer packaging material 30. The metal layer of the laminate material as the inner core material 40 may be made of the same material as the metal layer of the laminate material as the outer packaging material 30, or may be made of a different material.

The resin layer of the laminate material as the inner core material 40 may suitably be the same material as the resin layer of the laminate material as the outer packaging material 30. From the viewpoint of thermally fusing the inner core material 40 to the outer packaging material 30, it is preferable that the resin layer of the laminate material as the inner core material 40 and the resin layer of the laminate material as the outer packaging material 30 are made of the same material.

The laminate material as the inner core material 40 may be produced by attaching a resin film to a metal foil or metal plate. The resin film may be a stretched film or a non-stretched film. An adhesive may be used for attachment.

The concave and convex shapes of the inner core material 40 may be formed into a corrugated shape by pressing, pleating or the like. It may not only be a corrugated shape, but also an embossed shape with concave and convex portions distributed like a houndstooth pattern.

The pressing may be a discontinuous press or a continuous press. Examples of the discontinuous press include a forming method using an upper mold and a lower mold, and Examples of the continuous press include a roll forming method. Examples of the roll forming method include a corrugated processing method.

In the forming method using an upper mold and a lower mold, each of the upper mold and the lower mold is formed so that the concave and convex portions are arranged alternately. Each concave portion of the upper mold corresponds to each convex portion of the lower mold, and each convex portion of the upper mold corresponds to each concave portion of the lower mold, and the upper mold and the lower mold are configured so that the concave and convex portions of each mold interlock with each other. The inner core before processing may be formed into a corrugated shape by sandwiching and pressing the inner core between the upper mold and the lower mold.

The corrugated processing method may be performed using a pair of corrugated rolls. Each corrugated roll is formed so that concave and convex portions are arranged alternately along a rotational direction on its outer circumferential surface. Each concave portion of one corrugated roll corresponds to each convex portion of the other corrugated roll, and each convex portion of one corrugated roll corresponds to each concave portion of the other corrugated roll, and the pair of corrugated rolls are configured so that their concave and convex portions interlock with each other. Then, by sandwiching the inner core material before processing between the pair of corrugated rolls and rotating them, the inner core material may be passed between the pair of corrugated rolls and formed into a corrugated sheet shape.

In a case in which embossing is performed in the roll forming method, a pair of embossing rolls may be used. For example, an embossing rolls are used, in which concave and convex portions of the embossing rolls are arranged alternately on the outer circumferential surface along a rotational direction and an axial direction. Furthermore, the pair of embossing rolls are arranged so that the concave portions of one embossing roll correspond to the convex portions of the other embossing roll, and the convex portions of one embossing roll correspond to the concave portions of the other embossing roll, so that the pair of embossing rolls are arranged so that the concave and convex portions interlock with each other. Then, the inner core material before processing is sandwiched between the pair of embossing rolls and rotated, and the inner core laminate material is passed between the pair of embossing rolls to process the concave and convex portions. This way makes it possible to produce an embossed inner core material with concave and convex portions distributed like a houndstooth pattern or the like.

In the continuous press processing, the inner core material processed with the concave and convex portions is cut to a predetermined length by a shear knife (shear cutting blade) or the like provided downstream of the processing device to form the inner core material 40. In the continuous press processing, the process may be performed continuously by roll-to-roll, and the production efficiency may be improved.

In a case in which the inner core 40 is formed of a laminate material, the reinforcing member 50 is preferably formed as a separate member from the inner core 40, as shown in FIGs 4 and 5.

In a case in which the inner core material 40 is made of resin like the ribs, the concave and convex shapes may be formed by vacuum molding. In a case in which the inner core material 40 is made of resin, it is preferable that the reinforcing member 50 is provided as a part of the inner core material 40 as shown in FIG. 6.

The reinforcing member 50 may be formed as an integral part together with other components, or may be inserted later.

In a case in which the reinforcing member 50 is provided as part of the inner core material 40 as shown in FIG. 6, the reinforcing member 50 may be provided in the inner core material 40 by insert molding.

A cross-sectional shape of the refrigerant flow path partitioned by the concave and convex shapes of the inner core material 40 may be a semicircle, a semi-ellipse, a polygonal shape such as a triangle, a rectangle or a pentagon, an irregular shape, or a combination of these.

The multiple concave and convex shapes may be arranged regularly or irregularly. Examples of an irregular arrangement include one in which the period of the concave portion and convex portion is not uniform. In the case of a regular arrangement, the period of the concave portions and the period of the convex portions may be the same or different.

In a case in which the cross-sectional shape of the refrigerant flow path is uniform, it is preferable to process the inner core material by continuous press processing from the viewpoint of production efficiency. In a case in which it is not uniform, it is preferable to process the inner core material by discontinuous press processing.

A refrigerant flows through the flow path that is partitioned into multiple parts by the concave and convex shape of the inner core material 40. A kind of the refrigerant is not particularly limited. Examples of the refrigerant include liquids such as water and organic solvents, and gases such as air. The water used as the refrigerant may contain components such as antifreeze.

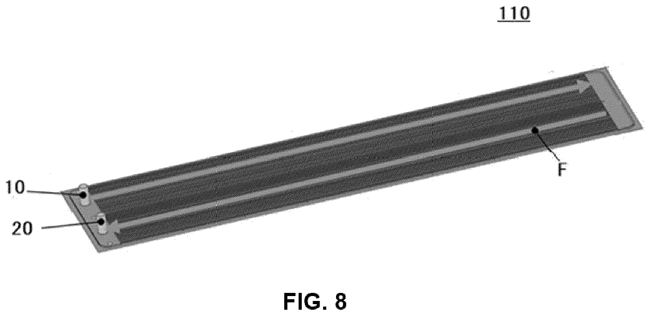

FIG. 8 is a schematic perspective view illustrating a modified example of the cooling structure, showing an interior in a case in which the upper outer packaging material 30B is removed.

In the cooling structure 100 of FIG. 1 and FIG. 2, the inlet 10 and outlet 20 for the refrigerant are provided at each end (front end, rear end) in the length direction. In contrast, in the cooling structure 110 of FIG. 8, both the inlet 10 and the outlet 20 are provided at one end. In the cooling structure 110 of FIG. 8, a joint pipe for the inlet 10 and a joint pipe for the outlet 20 are provided in the header section.

In the cooling structure 110 of FIG. 8, as shown by the arrow F in the figure, the refrigerant that flows from the inlet 10 of the header part 12 makes a U-turn at the footer part 22, reverses direction, and returns to the outlet 20 of the header section 12.

In FIG. 8, the refrigerant makes one round trip in the length direction, but it may make one and a half round trips. In this case, the header part 12 may be provided with an inlet 10, and the footer part 22 may be provided with an outlet 20. A number of times the refrigerant travels back and forth may be further increased.

In a case in which the refrigerant travels back and forth in the length direction, it is preferable to provide a partition between the forward flow path and the return flow path.

In yet another embodiment, there may be two or more inlets 10 and outlets 20, rather than just one each.

The cooling structure in the present disclosure may be widely used to cool heat-generating bodies, and is effective for cooling, for example, electronic devices such as smartphones and personal computers, battery modules mounted on electric vehicles, hybrid vehicles or the like, and power semiconductor modules.

### <Structure>

The structure in the present disclosure includes the cooling structure in the present disclosure described above, and an object to be cooled provided on the cooling structure.

Examples of the object to be cooled include heat-generating electronic devices such as smartphones and personal computers, battery modules mounted on electric vehicles and hybrid vehicles or the like, and power semiconductor modules.

The object to be cooled may be provided on either the outer packaging material 30B side or the outer packaging material 30A side of the cooling structure 100, or may be provided on both sides.

The present disclosure of Japanese Patent Application No. 2022-099723 is incorporated herein by reference in their entirety.

All documents, patent applications, and technical standards described in the present specification are incorporated herein by reference to the same extent as if each individual document, patent application, or technical standard were specifically and individually indicated to be incorporated by reference.

### Explanation of References

- 10: Inlet for refrigerant
- 20: Outlet for refrigerant
- 30, 30A, 30B: Outer packaging material
- 40: Inner core material
- 42: Convex portion
- 44: Concave portion
- 50: Reinforcing member
- 100, 110: Cooling structure

## Claims

1. A cooling structure comprising an outer packaging material having an inlet and an outlet for a refrigerant, and an inner core material disposed inside the outer packaging material, wherein:
the inner core material comprises a resin, and
the cooling structure is provided with a reinforcing member that reinforces the inner core material and that is disposed inside the outer packaging material

2. The cooling structure according to claim 1, wherein the reinforcing members are disposed symmetrically in a width direction of the cooling structure.

3. The cooling structure according to claim 1, wherein a height of the reinforcing member is 70% or more of a distance in the thickness direction of the cooling structure inside the outer packaging material.

4. The cooling structure according to claim 1, wherein the outer packaging material comprises a metal layer and a resin layer disposed on at least one side of the metal layer.

5. The cooling structure according to claim 1, wherein the inner core material comprises a metal layer and a resin layer disposed on both sides of the metal layer.

6. A structure comprising the cooling structure according to any one of claims 1 to 5 and an object to be cooled provided on the cooling structure.
